# EUROPEAN PATENT APPLICATION

(11) **EP 4 389 853 A1**
(43) Date of publication of application: **26.06.2024**
(21) Application number: 23214776.9
(22) Date of filing: 06.12.2023
(51) Int. Cl.: C09K 11/77

(54) **PLASMONIC EUTECTIC MATERIAL DOPED WITH RARE EARTH IONS WITH ENHANCED UP CONVERSION AND METHOD OF ITS OBTAINING**

(30) Priority: 21.12.2022 PL 44322922
(71) Applicant: Uniwersytet Warszawski, 00-927 Warszawa (PL); Ensemble3 spolka z ograniczona odpowiedzialnoscia, 01-919 Warszawa (PL)
(72) Inventor: PAWLAK, Dorota, 01-885 Warszawa (PL); PIOTROWSKI, Piotr, 03-507 Warszawa (PL); SADECKA, Katarzyna, 04-163 Warszawa (PL); SURMA, Barbara, 02-695 Warszawa (PL); RACZKIEWICZ, Marcin, 02-496 Warszawa (PL)
(74) Representative: JD&P Patent Attorneys Joanna Dargiewicz & Partners

(57) **Abstract**

The present invention relates to a plasmonic eutectic material, doped with rare earth (RE) ions, which exhibits up-conversion in the range between 500 nm and 700 nm when illuminated with a light of 980 nm wavelength. As a result of annealing this material, the up-conversion intensity in this range is enhanced. The invention has applications in photovoltaics based on the up-conversion mechanism.

The present invention also relates to a method for fabricating eutectic material.

## Description

An object of the invention is a eutectic material doped with rare earth (RE) ions, which exhibits photon upconversion (referred to as 'up-conversion') as a result of light absorption, and a method for obtaining it. Advantageously, the object of the invention is a eutectic material doped with rare earth ions (RE) which exhibits up-conversion in the wavelength range between 500 nm and 700 nm as a result of the light absorption at 980 nm. As a result of annealing of this material, an enhancement of the up-conversion intensity in this range occurs. The invention can find application in photovoltaics, for example. The upconverting structure (a eutectic material containing rare earth ions) is suitable for the bottom layer of a solar photovoltaic cell, making it possible to increase the efficiency of converting solar energy into electricity by increasing the absorption of silicon.

The up-conversion process involves a material emitting radiation of a shorter wavelength (higher energy) when excited with radiation of a longer wavelength (lower energy). An example of this type of phenomenon is the emission of green and red light when excited with infrared radiation.

Composites consisting of a metallic matrix with dielectric nanostructures or a dielectric matrix with metallic nanostructures have plasmonic properties, which are related to the presence of localised surface plasmons, i.e. vibrations of free carriers in nanometric objects with a negative value of real part of electric permittivity.

By using plasmonic nanostructures, numerous optical processes can be influenced. From the publication by Ströhhofer C., Polman A., Appl. Phys. Lett., 2002, 81, 1414, the enhancement of the luminescence intensity of the rare earth - ion erbium with silver nanoparticles is known. From publications by Aisaka, T., Fujii, M., Hayashi, S. Appl. Phys. Lett. 2008, 92, 132105 and Atre, A. C., Gracia-Etxarri, A., Alaeian, H., Donne, J. A., J. Opt., 2012, 14, 024008 the influence of plasmonic effects on up-conversion processes is known.

Photon emission due to the excitation of rare earth ions in composites with metallic nanostructures where rare earth ions are in the presence of metallic nanostructures can be much higher (up to several orders of magnitude) than for materials without metallic nanostructures, as known from the publications of Gajc, M, Surma, H. B., Klos, A., Sadecka, K., Orlinski, K., Nikolaenko, A. E., Zdunek, K., Pawlak, D. A., Adv. Funct. Mat 2013, 23, 3443-3451 and Trave, E., Mattei, G., Mazzoldi, P., Pellegrini, G., Scian, C., Maurizio, Ch., Battaglin, G., Appl. Phys. Lett. 2006, 89, 151121.

Up-conversion mechanisms using metallic nanoparticles are mainly studied in glass composites that contain metallic nanoparticles and rare earth ions. They are based on the doping of glass matrices with the desired metal ions, and their subsequent reduction to metallic nanoparticles. From the publications of Wu, Y., Shen, X., Dai, S., Xu,Y., Chen, F., Lin, Ch., Xu, T., Nie, Q., J. Phys. Chem. C, 2011, 115 (50), 25040-25045 and Kassab, L. R. P., Bomfim, F. A., Martinelli, J. R., Wetter, N. U., Neto, J. J., de Araújo, Cid B., Appl. Phys. B, 2009, 94, 2, 239-242 direct doping with compounds containing the desired metallic ions in the composition is known.

In the case of the eutectic materials to which this application relates, there are few papers on up-conversion in eutectics only. From the publications of Balda, R., Garcia-Revilla, S., Fernández, J., et. al. Journal of Luminescence 129(12), pp. 1422-1427 and Balda, R., Merino, R.I., Peña, J.I. et al. Optical Materials 31(7), pp. 1105-1108, the doping of eutectic materials with rare earth ions is known. However, these works present oxide-oxide eutectics whose constituent elements are Ca or Zn. In contrast, one does not find work describing up-conversion in metal-oxide eutectics with plasmonic nanoparticles, where such upward energy conversion would be plasmonically enhanced.

The aim of the present invention was to develop a new eutectic material exhibiting up-conversion, especially plasmonically enhanced conversion.

This objective has been achieved by the eutectic material according to the present invention and the method for obtaining it.

Thus, the object of the present invention is a plasmonic eutectic material which consists of three components:
- phase A, which is 51 - 99 mol % of metal oxide, constituting a dielectric matrix with a positive real part of electrical permittivity Re(eps) > 0 for the electromagnetic λ wavelength range of UV/Vis/NIR,
- phase B, which is 1 - 49 mol % of metallic or semiconducting precipitates with a resistivity not exceeding 150 nΩm, and a negative effective electrical permittivity Re(eps) < 0 for the same λ wavelength range, and
- phase C, which is made up of dopants of at least one rare earth element in the form of ions, in a total concentration of not more than 4 mol %.

Advantageously, the plasmonic eutectic material consists of three components:
- 70.0 - 86.0 mol % of Bi₂O₃ constituting the dielectric matrix, with a positive real part of electrical permittivity Re(eps) > 0 for the electromagnetic λ wavelength range of 172 nm - 258 nm and above 326 nm,
- 14.0 - 18.0 mol % of Ag constituting metallic or semiconducting precipitates with a resistivity of 15.87 nΩm, with negative real part of electrical permittivity Re(eps) < 0 for the same λ wavelength range of 172 nm - 258 nm and above 326 nm, preferably with low optical loss, i.e. imaginary electrical permittivity value Im(eps) of 1.79 - 3.6 F/m and from 0.579 F/m for Re(eps) < 0.2, and
- 1-4% mol of at least one rare earth element in ionic form.

Advantageously, the metallic or semiconductor precipitates are no larger than 500 nm in size.

Advantageously, the plasmonic eutectic material consists of:
- 15.4 mol % of Ag with Re(esp) < 0,
- 84.6 mol % of doped non-metallic phase, which consists of:
- 97 mol % of Bi₂O₃ with Re(esp) > 0.4 and
- 3 mol % of Er₂O₃.

Advantageously, the plasmonic eutectic material consists of:
- 15.4 mol % of Ag with Re(esp) < 0,
- 84.6 mol % of doped non-metallic phase, which consists of:
   - 96 mol % of Bi₂O₃ with Re(esp) > 0.4 and
   - 3 mol % of Er₂O₃
   - 1 mol % of Yb₂O₃.

It is also an object of the present invention to provide a method for producing the plasmonic eutectic material defined above, comprising the steps wherein
a) components:
   - phase A, which is 51 - 99 mol % of metal oxide, constituting a dielectric matrix with a positive real part of electric permittivity Re(eps) > 0 for the electromagnetic λ wavelength range of UV/Vis/NIR,
   - phase B, which is 1 - 49 mol % of metallic or semiconducting precipitates with a resistivity not exceeding 150 nΩm, and a negative real part of electrical permittivity Re(eps) < 0 for the same λ wavelength range, and
   - phase C, which is made of dopants of at least one rare earth element in the form of ions, in a total concentration of not more than 4 mol %,
   are ground in suspension in propanol,
(b) the resulting material is heated in a resistance furnace to a temperature of 100°C in order to evaporate the propanol;
(c) the prepared material is placed in a crucible, which is then mounted in a system for directional micro-pulling-down from the melt,
(d) micro-pulling-down of a rod from the melt is carried out in a temperature range of 650 - 700°C;
(e) the resulting eutectic rod is cut into approximately 1 mm thick samples;
(f) the samples are placed in a resistance furnace and heat-treated in an oxidising atmosphere or in a vacuum, the annealing being carried out at a temperature of 600°C for at least 30 minutes.

Advantageously, the samples obtained in step f) are polished on both sides to a thickness of less than 100 µm.

Advantageously, as components: phase A, phase B and phase C are used:
- 70.0 - 86.0 mol % of Bi₂O₃, constituting a dielectric matrix with a positive real part of electric permittivity Re(eps) > 0 for the electromagnetic λ wavelength range of 172 nm - 258 nm and above 326 nm,
- 14.0 - 18.0 mol % of Ag constituting metallic or semiconducting precipitates with a resistivity of 15.87 nΩm, with a negative real part of electric permittivity Re(eps) < 0 for the same λ wavelength range of 172 nm - 258 nm and above 326 nm, preferably with low optical losses, i.e. an imaginary value of the electrical permittivity Im(eps) of 1.79-3.6 F/m and from 0.579 F/m for Re(eps) < 0.2, and
- 1 - 4 mol % of at least one rare earth element in ionic form.

Advantageously, the metallic or semiconductor precipitates are not larger than 500 nm in size.

Advantageously, the plasmonic eutectic material consists of:
- 15.4 mol % of Ag with Re(esp) < 0,
- 84.6 mol % of doped non-metallic phase, which consists of:
- 97 mol % of Bi₂O₃ with Re(esp) > 0.4 and
- 3 mol % of Er₂O₃.

Advantageously, the plasmonic eutectic material consists of:
- 15.4 mol % Ag with Re(esp) < 0,
- 84.6 mol %of doped non-metallic phase, which consists of:
- 96 mol % of Bi₂O₃ with Re(esp) > 0.4 and
- 3 mol % of Er₂O₃.
- 1 mol % of Yb₂O₃.

The proposed eutectic material is a eutectic matrix consisting of two phases, in which one phase is an oxide dielectric and the other phase is silver and bismuth nanoparticles, which are formed as a consequence of annealing. In addition, the eutectic is doped with rare earth ions. Rare- earth ions of the lanthanide group, of Er and Yb kind, exhibit luminescence bands characteristic of this ion. When co-doping with Er and Yb rare earth ions, the material exhibits luminescence bands characteristic of Er ions, while Yb serves as an energy transmitter in the up-conversion process. An external electromagnetic field induces a plasmonic resonance in the metallic nanoparticles. The electric field of the excited nanoparticles amplifies the external electric field, which ultimately results in a significant enhancement of ion/ions luminescence in the wavelength range of 520 - 580 nm and 630 - 700 nm, namely, the up-conversion phenomenon occurs.

The material according to the invention is characterised in that it consists of at least two components: 51 - 99 mol % of phase A, constituting a dielectric matrix with a positive real part of electric permittivity Re(eps) > 0 for the electromagnetic λ wavelength range of UV/Vis/NIR, and 1 - 49 mol % of phase B, being metallic or semiconducting precipitates with resistivity not exceeding 150 nΩm and a negative real part of electric permittivity Re(eps) < 0 for the same λ wavelength range and phase C which is made up of dopants in the form of rare-earth ions (single or double doping) in a total concentration not exceeding 4 mol %, respectively.

Preferably, the material consists of 14.0 - 18.0 mol % of Ag with a melting point of 961.78°C, with electrical resistance of 15.87 nΩm with Re(eps) < 0 for the λ wavelength ranges of 172 nm - 258 nm and from 326 nm, with Im(eps) for the same λ wavelength ranges respectively 1.79 - 3.6 F/m and from 0.579 increasing proportionally with the λ wavelength and 70.0 - 86.0 mol % of Bi₂O₃ with melting point of 817°C with Re(eps) > 0 and 1-4 mol % of RE, being made of rare earth ions selected from erbium (Er³⁺) and ytterbium (Yb³⁺).

The material according to the invention is applicable, as required, in various forms of rods, strips or layers or in suitably prepared fragments thereof.

The example given below illustrates the material according to the invention in a particular embodiment, without limiting the scope of its use, based on the drawing in which:

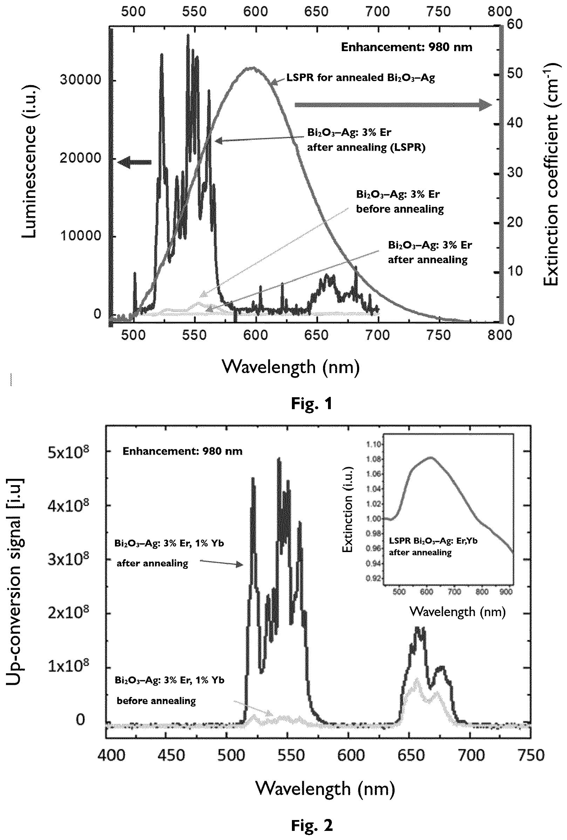

Fig.1 presents a graph of up-conversion and extinction coefficient versus λ wavelength for Bi₂O₃ - Ag eutectic, doped with Er³⁺ ions, before and after annealing. There is an apparent increase in the up-conversion intensity in the visible range, as well as an extinction maximum after annealing in the 590 nm range associated with the occurrence of LSPR (Localized Surface Plasmon Resonance) in the resulting material.
Fig. 2. presents a graph of up-conversion and extinction coefficient versus λ wavelength for Bi₂O₃ - Ag eutectic doped with Er³⁺/Yb³⁺ ions before and after annealing. An increase in the up-conversion intensity in the visible range is evident.

### EXAMPLES

### Example 1: single doping

In a ceramic mortar, the components are ground in suspension in propanol of 15.4 mol % Ag with a melting point of 961.98°C and 84.6% mol of the non-metallic phase containing Bi₂O₃ and the dopants in an amount of: 97% Bi₂O₃ with a melting point of 817°C and 3 mol % Er₂O₃ (single doping). The resulting material is then heated in a resistance furnace to a temperature of 100°C to evaporate propanol. The material prepared in this way is placed in a crucible, which is then mounted in micro-puling down furnace. The main process of obtaining a rod is carried out in a nitrogen atmosphere in a temperature range of 650 - 700°C.

The eutectic rod thus obtained is cut into samples about 1 mm thick, which are then placed in the resistance furnace and heat treated in an oxidizing atmosphere or vacuum. Annealing is carried out at a temperature of 600°C, for at least 30 minutes. Then the plates are double sided polished below the thickness of 100 µm.

Plasmonic properties are determined by spectroscopic examination. Annealing causes dispersion of the metallic phase and formation of the metallic nanoparticles of silver and bismuth. Such a structure in the metallodielectric material produces Localized Surface Plasmon Resonance, LSPR, at a wavelength of 590 nm. Up-conversion processes (with an excitation wavelength of 980 nm) occur only for the eutectic material Bi₂O₃ - Ag : Er. For this material, as a result of the up-conversion, green emission in the spectral range of 520 - 580 nm and emission in red in the spectral range of 630 - 700 nm are observed. In the case of Bi₂O₃ : Er materials, both before and after annealing, the up-conversion phenomenon has not been observed. After the material Bi₂O₃ - Ag : Er material is annealed, the intensity of up-conversion increases significantly. The enhancement in the annealed material is probably related to the localized surface plasmon resonance, which is the result of the presence of silver nanoparticles. The resonant band range in Bi₂O₃ - Ag: 3 mol % Er material (after annealing) coincides with the luminescent band range for erbium, which confirms the plasmonic up-conversion enhancement.

### Example 2: co-doping

In a ceramic mortar, the components are ground in suspension in propanol of 15.4 mol % Ag with a melting point of 961.98°C and 84.6% mol of the non-metallic phase containing Bi₂O₃ and the dopants in an amount of: 96% Bi₂O₃ with a melting point of 817°C and the dopants of rare earth ions in the form of: 3 mol % of Er₂O₃ and 1 mol % of Yb₂O₃ (double doping). The resulting material is then heated in the resistance furnace to a temperature of 100°C to evaporate propanol. The material prepared in this way is placed in a crucible, which is then mounted in micro-puling down furnace.. The main process of obtaining a rod is carried out in a nitrogen atmosphere in a temperature range of 650 - 700°C.

The eutectic rod thus obtained is cut into samples about 1 mm thick, which are then placed in a resistance furnace and heat treated in an oxidizing atmosphere or vacuum. Annealing is carried out at a temperature of 600°C, for at least 30 minutes. Then the samples are double sided polished below the thickness of 100 µm.

Plasmonic properties are determined by spectroscopic examination. Annealing causes dispersion of the metallic phase and formation of the metallic nanoparticles of silver and bismuth. Such a structure in the metallodielectric material results in Localized Surface Plasmon Resonance, LSPR, at a wavelength of about 615 nm. Up-conversion processes (with an excitation wavelength of 980 nm) occur with the highest efficiency for the eutectic material: Bi₂O₃ - Ag 3 % Er, 1 % Yb. For this material, as a result of the up-conversion, emission in green in the spectral range of 520 - 580 nm and emission in red in the spectral range of 630 - 700 nm are observed. After the material Bi₂O₃ - Ag: Er, Yb is annealed, the intensity of up- conversion increases significantly, especially in the green range. The enhancement in the annealed material is probably related to localized surface plasmon resonance, which is the result of the presence of silver nanoparticles. The resonant band range in Bi₂O₃ - Ag material: 3 % Er, 1 % Yb (after annealing) coincides with the luminescent band range for erbium, which confirms the plasmonic up-conversion enhancement.

## Claims

1. Plasmonic eutectic material, **characterized in that** it consists of three components:
- phase A, which is 51 - 99% mol of metal oxide, constituting a dielectric matrix with positive real part of electric permittivity Re(eps) > 0 for the electromagnetic λ wavelength range of UV/Vis/NIR,
- phase B, which is 1 - 49 mol % of metallic or semiconductor precipitation with a resistance not exceeding 150 nΩm, with negative real part of electrical permittivity Re(eps) < 0 for the same λ wavelength range and
- phase C, which is made up of dopants of at least one rare earth element in the form of ions, in a total concentration of not more than 4% mol.

2. Plasmonic eutectic material according to claim 1, **characterized in that** it consists of three components:
- 70.0 - 86.0 mol % of Bi₂O₃ constituting a dielectric matrix, with positive real part of electric permittivity Re(eps) > 0 for electromagnetic λ wavelength range of 172 nm - 258 nm and above 326 nm, respectively,
- 14.0 - 18.0 mol % of Ag constituting metallic or semiconductor precipitations with a resistance of 15.87 nΩm, with negative real part of electrical permittivity Re(eps) < 0 for the same λ wavelength range of 172 nm - 258 nm and above 326 nm, preferably at low optical losses, that is, the imaginary value of electric permittivity Im(eps) of 1.79 - 3.6 F/m and from 0.579 F/m for Re(eps) < 0.2, and
- 1 - 4% mol of at least one rare earth element in the form of ions.

3. Plasmonic eutectic material according to claim 1 or 2, **characterized in that** the metallic or semiconductor precipitations are not more than 500 nm in size.

4. Plasmonic eutectic material according to claims 1 or 2 or 3, **characterized in that** it consists of:
- 15.4 mol % of Ag with Re(esp) < 0,
- 84.6 mol % of doped non-metallic phase, which consists of:
- 97 mol % of Bi₂O₃ with Re(esp) > 0.4 and
- 3 mol % of Er₂O₃.

5. Plasmonic eutectic material according to claims 1 or 2 or 3, **characterized in that** it consists of:
- 15.4 mol % of Ag with Re(esp) < 0,
- 84.6 mol % of doped non-metallic phase, which consists of:
- 96 mol % of Bi₂O₃ with Re(esp) > 0.4 and
- 3 mol % of Er₂O₃
- 1 mol % of Yb₂O₃.

6. Method for producing a plasmonic eutectic material defined in any of claims 1 to 5, **characterized in that** it comprises the steps in which:
a) components:
- phase A, which is 51 - 99 mol % of metal oxide, constituting a dielectric matrix with positive real part of electric permittivity Re(eps) > 0 for the electromagnetic λ wavelength range of UV/Vis/NIR,
- phase B, which is 1 - 49 mol % of metallic or semiconductor precipitation with a resistance not exceeding 150 nΩm, with negative real part of electrical permittivity Re(eps) < 0 for the same λ wavelength range and
- phase C, which is made up of dopants of at least one rare earth element in the form of ions, in a total concentration of not more than 4 mol %, or,
are ground in suspension in propanol,
b) the resulting material is heated in a resistance furnace to a temperature of 100°C in order to evaporate the propanol;
c) the prepared material is placed in a crucible, which is then mounted in a mounted in micro-puling down furnace, and,
d) the growth of the rod from the melt is carried out in a temperature range of 650 - 700°C;
e) the resulting eutectic rod is cut into samples about 1 mm thick;
f) the plates are placed in a resistance furnace and heat-treated in an oxidising atmosphere or vacuum, the annealing being carried out at a temperature of 600°C for at least 30 minutes.

7. Method according to claim 6, **characterized in that** the plates obtained in step f) are double sided polished to a thickness below 100 µm.

8. Method according to claim 6 or 7, **characterized in that** as components, phase A, phase B and phase C are used:
- 70.0 - 86.0 mol % of Bi₂O₃ constituting a dielectric matrix, with positive real part of electric permittivity Re(eps) > 0 for electromagnetic λ wavelength range of 172 nm - 258 nm and above 326 nm,
- 14.0 - 18.0 mol % of Ag constituting metallic or semiconductor precipitations with a resistance of 15.87 nΩm, with negative real part of electrical permittivity Re(eps) < 0 for the same λ wavelength range of 172 nm - 258 nm and above 326 nm, preferably at low optical losses, that is the imaginary value of electric permittivity Im(eps) of 1.79 - 3.6 F/m and from 0.579 F/m for Re(eps) < 0.2, and
- 1-4% mol of at least one rare earth element in the form of ions.

9. Method according to any of claims 6 to 8, **characterized in that** as components phase A, phase B and phase C are used:
- 15.4 mol % of Ag with Re(esp) < 0,
- 84.6 mol % of doped non-metallic phase, which consists of:
- 97 mol % of Bi₂O₃ with Re(esp) > 0.4 and
- 3 mol % of Er₂O₃.

10. Method according to any of claims 6 to 8, **characterized in that** as components phase A, phase B and phase C are used:
- 15.4 mol % of Ag with Re(esp) < 0,
- 84.6 mol % of doped non-metallic phase, which consists of:
- 96 mol % of Bi₂O₃ with Re(esp) > 0.4 and
- 3 mol % of Er₂O₃
- 1 mol % of Yb₂O₃.
